Europäisches Patentamt

European Patent Office

Office européen des brevets

(11) Publication number: **0 308 980**
**A2**

(12) **EUROPEAN PATENT APPLICATION**

(21) Application number: 88115769.7

(51) Int. Cl.⁴: **H01L 23/48 , H01R 9/09**

(22) Date of filing: **24.09.88**

(30) Priority: **24.09.87 US 100809**
**09.08.88 US 230660**

(43) Date of publication of application:
**29.03.89 Bulletin 89/13**

(84) Designated Contracting States:
**CH DE FR GB IT LI**

(71) Applicant: **ELASTOMERIC TECHNOLOGIES, INC.**
**ETI 2940 Turnpike Drive**
**Hatboro, PA 19040(US)**

(72) Inventor: **Buchoff, Leonard S. Elastomeric Technologies, Inc.**
**2940 Turnpike Drive**
**Hatboro, PA 19040(US)**
Inventor: **Black, James K.**
**PSC No. 1798**
**Williams AFB Arizona 85240(US)**

(74) Representative: **Königseder, geb. Egerer, Claudia**
**Zugspitzstrasse 65**
**D-8104 Grainau(DE)**

(54) **Flat wire in silicone rubber or matrix MOE.**

(57) The invention relates to flat wire electronic connections comprising rectangular conductive ribbins (2) with a high bonding surface to cross-sectional ratio, and an elastomeric material circumscribing the conductive ribbons (2).

FIG. 5

FIG. 3

SECTION A-A

FIG. 4

EP 0 308 980 A2

## FLAT WIRE IN SILICONE RUBBER OR MATRIX MOE

The invention relates to electronic connections, and more particularly to connections employing conductive ribbons circumscribed by elastomeric material and having high bonding area to cross-sectional area ratios.

Electronic connections are often made to very small connector pads having closely spaced centers where fine wires of aluminum or gold are bonded between mating pads by ultrasonic wedge bonding or thermo-compression. These techniques are employed to bond leads on semiconductor chips to larger circuit substrates. However, since each lead must be singularly bonded, these methods are costly and time consuming. Additional problems arise because substrates must be rigid and able to withstand the heat required for the particular bonding technique and the bonding surfaces must be of specific metallurgical compositions and must remain clean and uncontaminated.

On larger components it is common practice to attach differently-shaped wires to the various components and solder the wires into plated through holes. Leads are also utilized on ceramic packages to be soldered to printed circuit boards having different coefficients of expansion for which flexibility of the leads can compensate. Such leads however, are expensive, easily misaligned and fragile, particularly on surface mounted devices. Also, solder may inadvertently bridge adjacent leads which are closely spaced, and handling of the components becomes more difficult. Additionally, soldering leads into place limits the composition of the contact pads to those easily wet by solder and limits the substrates to those able to withstand temperatures necessary for soldering.

Elastomeric connectors have been employed in a wide variety of applications from LCD watches to sophisticated computers and military equipment. "Elastomers" include the full spectrum of elastic polymers which are sometimes arbitrarily called rubbers, synthetic rubbers or elastomers, although correctly speaking, rubber is a natural material and synthetic rubbers are polymers synthesized to produce properties not available in natural rubber. These connectors mate to any conductive surface, alleviating concern about metallurgical compatibility as when connections are made by soldering, since the connection is completed by merely sandwiching the elastomeric element between the mating substrates. Recently, a myriad of elastomeric connectors have been developed to produce closely spaced contacts. Typical is the"Zebra"made by Tecknit and the "STAX", made by PCK Elastomerics.

There are two main classes of elastomeric connectors: one class of layered elastomeric connectors (LEC) comprises alternate layers of conductive and non-conductive silicon rubber; the other main class comprises metal paths positioned on the surface or within the elastomer body.

Carbon-filled, layered elastomeric connectors have been widely used because of their reliability, ease of use and cost effectiveness. However, the soft conductive rubber makes unreliable contact with contaminated surfaces. These connectors are limited to few very high impedance circuits, since they possess very high contact resistances because carbon is used as the conductive element. When the layered connectors contain silver, the resistance is lower, i.e., to approximately a few tenths of an ohm. However, this resistance is still too high for many present day circuits. Silver contacts must not be left unmated where sulfur contamination is present since the contacts will develop a non-removable, silver sulfide coating. Of course, the cost of silver and the high concentrations needed in such connectors (typically 45% by weight of the total connector), make these connectors economically unviable in large applications. To obtain the greatest conductivity, metal traces deposited on the surface of silicone rubber are used, taking advantage of the excellent electrical, chemical and thermal properties of silicone rubber.

Most of the metal-on-elastomer (MOE) elements make multiple contacts with the substrates. Since the connector elements have a pitch exceeding that of the devices and printed wiring boards, special alignment of connector elements is unnecessary. Conductive lines between mated pads and insulated areas between adjacent pads always exist.

A further variation of an elastomeric connector comprises metal paths on a film backing such as Mylar® or Kapton®, which circumscribes a cylinder of rubber. While this technology allows fine line definition, there are several drawbacks. First, the film is more rigid than the rubber core and does not follow the substrate's contours as would a bare rubber cylinder. Thus, asperities on a substrate could cause a fine line to be missed. Second, producing a good bond between the film and rubber has proved difficult. Generally, the film is cemented to itself, resulting in a tail which often interferes. Also, an area with two layers of film and adhesive produces a very rigid local structure. The adhesives used previously softened at temperatures below 38°C producing a number of failures, even before connectors were installed. If these connectors were slightly bent, the outer film layer wrinkled unalterably destroying the affected parts.

A further type of connector generally comprises two rows of evenly spaced round or slightly flattened metal wires embedded in a silicone rubber matrix. However, these connectors have never been commercially successful because of their unreliability upon overstress. In production of these connectors, the wires are stretched taut to lie perpendicular to the cut ends of the connector. When this perpendicularity is not retained, the contacts do not lie directly above one another, causing incorrect coupling of electrical signals. Thus, only wires which can be stretched without elongation or breakage such as stainless steel or moderately strong copper alloys, may be used. Since the ends of the wires are exposed, they must be reasonably noble to prevent insulating oxides or other contamination. The high elastic modulus of the wire (typically 10,000 times higher than the silicone rubber's elastic modulus) causes the wires to occasionally not return to their original height with the silicone rubber surrounding them.

Moderate deflections will cause the metal to remain depressed below the surface level of the rubber when the clamping force by which the connectors are sandwiched between two parallel surfaces is removed, even if the adhesive bond remains intact. Also, if excessive vibration occurs or if the connector is deflected and then redeflected, contacts are lost. Then, on the next mating impression cycle, ths rubber is deflected and some of the metal contacts are not made, producing open circuits. Since an important aspect of silicone rubber connectors is the ability to be mounted and uncoupled, this loss of contact is not acceptable.

Still another type of elastomeric connector comprises conductive lines of metal particles suspended in a rubber or resin matrix screened onto silicone rubber or silicone sponge. These lines possess high resistance and will therefore carry only very low currents and have proven unreliable in many applications.

Several companies produce connectors comprising round or square wires embedded in a rubber or foam matrix. On deflection between two mating surfaces, these wires establish electrical contact between corresponding pads. The sharp wire ends are effective in penetrating the insulating deposits on the contact pads. The major drawback of this scheme is the tendency of the wires to remain deflected when the pressure is released on the joint. It has been found that overdeflecting more than 5% causes this unfavorable condition.

Accordingly, it is an object of the present invention to produce connectors whose conductive elements do not remain deflected when pressure is released on the joint.

Another object of the invention is to produce connectors which will not require substrates to be rigid or to withstand the high temperatures of soldering or brazing.

These and other objects are achieved by the use of the electronic connection as set forth in the appended claims.

The electronic connector of the present invention comprises very thin, parallel metal lines between 2,5 $\mu$m and 25 $\mu$m thick, formed without stress and embedded in an elastomeric silicone rubber or foam. Individual lines are relatively narrow, typically from 25 $\mu$m to 250 $\mu$m wide. The lines are generally created from highly ductile metals, such as pure, stress-free copper or gold. The metal lines, by their flat nature, have a high surface to cross-sectional area ratio, which provides the silicone rubber with sufficient surface to maintain a good adhesive bond. Thus, when pressure is applied and released, the metal lines remain in the same position in the rubber so that the ends of the metal are even with the outer surface of the silicone rubber. This occurs because the lines are so thin that the force required to deflect them is an order of magnitude less than that of a round wire of equal cross-sectional area. Various experiments have shown that where the units were deflected 300 times by 17%, the electrical integrity remained intact.

Laboratory tests have revealed that the entire matrix MOE body bends as a unit because the individual traces are aligned precisely in the same direction. In the tests, matrix MOEs were flexed over 250,000 times without losing contact.

The present connectors are generally placed into slots in a holder body. These slots are wide enough to allow for increase in the width of the connecting elements during deflection and are typically of a height to establish a deflection stop. Because of the mass of silicone rubber surrounding the metal contacts on these connectors, they are, for the most part, impervious to the atmosphere. However, the sharp ends of the metal lines make reliable contacts even to somewhat contaminated surfaces. These connectors are economically produced in large quantities with highly automated equipment.

The present linear connectors should be very useful in making connections between rows of contacts such as printed circuit board to printed circuit board, hybrid to board, chip carrier to board, and other similar applications.

The present connectors may also be made to comprise a multitude of lines of these wires spaced relatively closely over an extended area. This connector is then able to make connection to an array of points in two dimensions. Foam between the wires may then be used to reduce the force necessary to establish and maintain contact.

Matrix connectors fill a very important need to produce connections between leadless pad grid arrays that are becoming increasingly popular in the electronics field. They could also be used as a universal testing interface between unpopulated circuits and ATE interfaces.

One of the important features to producing the present connector in an efficient, cost effective manner lies in construction of the plating mandril. The metal of the mandril must be capable of being plated with the appropriate metals, without being affected by the solutions and other processes, yet retain sufficient adhesion so that the lines remain in place, while having a sufficiently low adhesion so that the silicone -metal laminate can be easily removed from the mandril. Several 300 Series stainless steels have been found to be successful in this regard. This mandril comprises a stainless steel sheet coated with photoresist and is imaged to produce the metal pattern desired. The photoresist pattern is coated with a release agent for silicone rubber such as polytetrafluoroethylene.

A less expensive mandril is a stainless steel sheet engraved so that the raised portion contains the lines to be produced. The sunken areas are filled with inert material which is unaffected by the plating solutions or other materials and processes to which it might be exposed. This surface must not bond to the silicone rubber. Application of polytetraflouroethylene has been effective in this regard. If properly done, these mandrils may last indefinitely with only an occasional surface buffing or cleaning between metal electrodepositions.

Typically, the metallization is accomplished by the following process: 1) electroforming the metal onto conductive mandrils; 2) applying silicone rubber to the mandrils; 3) lifting the silicone-metal laminate from the mandrils; 4) laminating several silicone-metal layers; and 5) cutting the connector elements to the appropriate height.

The initial rubber applied to the plated line, can be a one part, moisture curing RTV silicone rubber, such as General Electric's RTV 162, which produces a strong adhesive bond. Other silicone rubbers of varying strengths and durometers can then be bonded to this first rubber layer and foam may also be applied. Unlike prior art processes, individual wires are positioned between sheets of uncured rubber and then vulcanized.

Matrix MOEs have been made by the applicant with several configurations and metallurgies. Typically, nickel traces 50 $\mu$m and 125 $\mu$m wide have been made as well as gold traces 12,5 $\mu$m thick with or without a 0,5 $\mu$m flash of nickel for adhesion. The gold traces are generally 50 $\mu$m wide on 100 $\mu$m centers, although gold matrix MOEs with traces 25 $\mu$m wide on 75 $\mu$m centers are being produced.

An alternate metallization involves traces comprised of 5 $\mu$m of tin-lead and 7,5 $\mu$m of copper. The MOE skins are laminated and individual elements are cut from the stack. Subsequently, the elements are heated to 240°C for a few minutes, causing the tin-lead solder to melt and flow over the cut ends of exposed copper, covering them completely and protecting the copper ends from corroding and forming an insulating barrier.

Among the various methods of producing the conductive lines, include:

1) A way of producing conductive lines is to bond foil of particular composition to the rubber and then etch by conventional methods such as photomasking and chemical etching. The silicone rubber may be initially cast onto the metal foil for high adhesion.

2) By another method, foil is applied to a backing to retain it in place. The desired lines are then produced by chemically etching or mechanically removing the unwanted metal. The rubber may be cast onto the metal surfaces and the backing may be removed with solvent, heat or mechanical stripping.

3) The lines may be initially created by electroless plating onto appropriately sensitized mandrils, and the silicone or other rubber may be applied and removed as described above.

4) The metal may be produced by evaporation or sputtering through an appropriate mask onto the silicone rubber or onto an intermediate transfer sheet.

5) The metal lines may be produced by thermal decomposition of particular gasses, reactions of gasses, or other chemical processes.

6) Metal salts such as oxides may be produced in the appropriate configuration and subsequently reduced or chemically changed to produce the metal lines.

7) Another method may also consist of metal powder in a binder applied to a surface by painting, silk screening, or other coating methods. The binder could then be burnt off and the metal lines could be produced by the sintering process until the particles flow and coalesce into a continuous line.

8) One may also take very fine foil, slit it, apply it to a stable substrate, apply the rubber, and then remove the backing.

9) Metal may be cast from the molten stage into appropriate forms, and then the rubber applied.

10) Another method involves taking a mandril having lines in correct position and dipping it in a bath of molten metal which could adhere to the mandril surface. On cooling, the metal would solidify, producing the required lines which could be coated.

11) Metal foil may be stamped to produce the lines. Metal could be evaporated onto an appropriate plastic carrier and hot stamped onto a base or onto the rubber to produce the appropriate lines, and then covered with more rubber.

12) Ductile wire may be flattened in appropriate dies to produce the required lines.

13) The silicone rubber may be applied by draw down, spray painting, flow coating, reaction casting, printing, silk screening, application from a rolled coater, or other appropriate methods. The rubber could be produced in place by reaction between two or more chemicals, by the loss of solvent from a solution or a combination of these processes. Other rubbers, such as urethane, butyl, EPR, neoprene, natural rubber, other synthetic rubbers, and rubber-like materials such as plasticized polyvinylchloride may be used.

FIGURE 1 is a perspective view of the flat wire in silicone rubber;

FIGURE 2 is a view of the flat wire itself, indicating a typical composition;

FIGURE 3 is a plan view of the flat wire in silicone rubber;

FIGURE 4 is a cross-sectional view of flat wire in silicone rubber along line A-A of Figure 3; and

FIGURE 5 is a more detailed view of the top portion of the flat wire in silicone rubber, indicating the general spacing between adjacent rows of conductors.

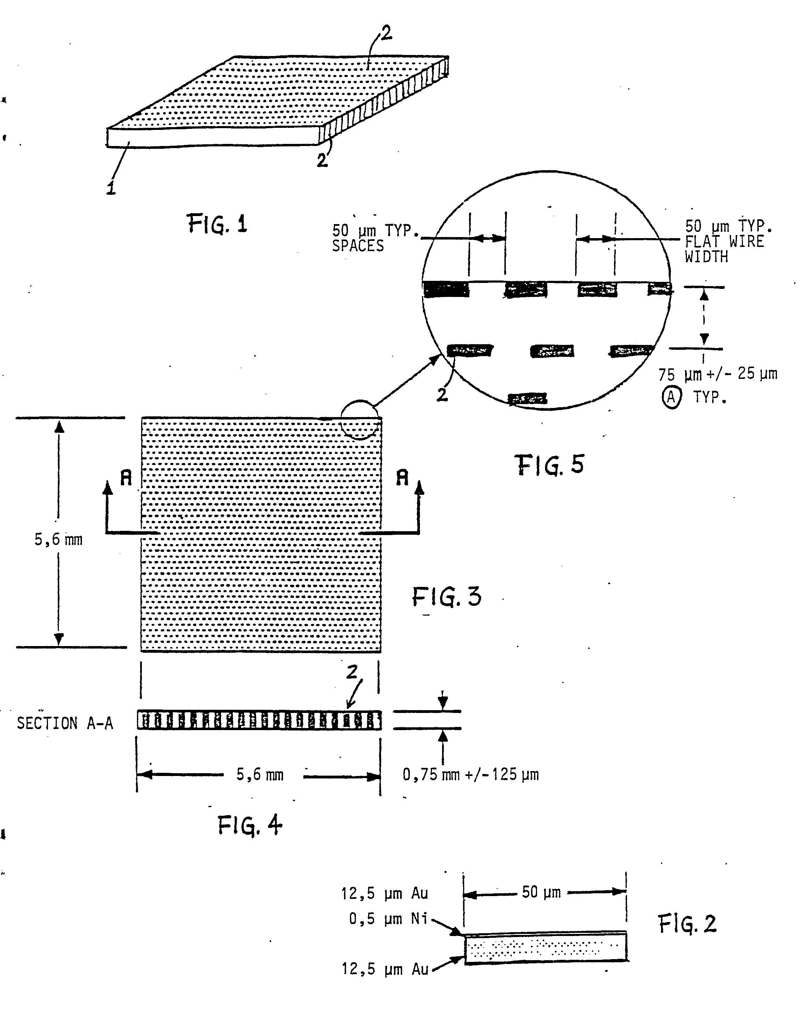

Referring now to the drawings where like numerals represent like elements throughout the several views, Figure 1 depicts an electronic connector 1, generally comprising a plurality of parallel flat wire conductors 2 as shown perspectively and in plan in Figure 3. A typical end view of a flat wire is shown in Figure 2.

Figure 4 is a cross-sectional view of the electronic connector 1 of Figure 3, along line A-A.

Figure 5 shows an area of connection 1 in greater detail indicating the general spacing between adjacent conductors rows of conductors. The conductors are shown in the elastomeric material in Fig. 5.

## Claims

1. An electronic connection comprising solid, substantially rectangular conductive ribbons, said ribbons having high bonding surface to cross-sectional ratio, and an elastomeric material circumscribing said ribbons for making electrical connections between a plurality of conductive surfaces.

2. The electronic connection of claim 1, characterized in that said elastomeric material is a silicone rubber.

3. The electronic connection of claims 1 and 2, characterized in that said conductive surfaces are contact pads.

4. The electronic connection of claims 1 to 3, characterized in that said conductive ribbons are aligned in rows and columns, comprising substantially a matrix pattern.

5. The electronic connection of claim 4 characterized in that each row is substantially parallel to another row.

6. The electronic connection of claims 1 to 5, characterized in that the number of ribbons per $cm^2$ is between 155 and 77.500.

7. The electronic connection of claims 1 to 5, characterized in that the number of ribbons per $cm^2$ is between 155 and 62.000.

8. The electronic connection of claims 1 to 5, characterized in that the number of ribbons per $cm^2$ is between 310 and 46.500.

9. The electronic connection of claims 1 to 5, characterized in that the number of ribbons per $cm^2$ is between 465 and 31.000.

10. The electronic connection of claims 1 to 5, characterized in that the number of ribbons per $cm^2$ is 775 (lower bound of the best range) and 15.500 (upper bound of the best range).

11. The electronic connection of claims 1 to 5, characterized in that conductive ribbons are between 0,025 $\mu$m and 25 $\mu$m thick.

12. The electronic connection of claims 1 to 5, characterized in that said conductive ribbons are between 0,25 $\mu$m and 25 $\mu$m.

13. The electronic connection of claims 1 to 5, characterized in that said conductive ribbons are between 0,50 $\mu$m and 17,5 $\mu$m.

14. The electronic connection of claims 1 to 5, characterized in that said conductive ribbons are between 7,5 $\mu$m and 17,5 $\mu$m.

15. The electronic connection of claims 1 to 5, characterized in that said conductive ribbons are between 0,10 $\mu$m and 17,5 $\mu$m.

16. The electronic connection of claim 4, characterized in that said matrix is square.

17. The electronic connection of claims 1 to 16, characterized in that said conductive ribbons are made of gold, copper, nickel, silver, a tin-lead alloy or a combination thereof.

18. The electronic connection of claims 1 to 16, characterized in that said conductive ribbons are made of copper and a coating of tin.

19. The electronic connection of claim 2, characterized in that said elastomeric material is a tripolymer of ethylene.

20. The electronic connection of claim 2, characterized in that said elastomeric material is a tripolymer of propylene or silicone rubber.

21. An electronic connection comprising solid, substantially rectangular conductive ribbons, aligned in substantially parallel rows comprising substantially a matrix, wherein said ribbons have a high bonding surface to cross-sectional ratio, characterized in that the number of said ribbons per cm$^2$ is between 775 (lower bound of the best range) and 31.000 (upper bound of the best range), and that said ribbons are between 0,10 $\mu$m and 17,5 $\mu$m thick, and that the said ribbons are made of gold, copper, nickel, silver, a tin-lead alloy or a combination thereof; and further comprising an elastomeric material made of a tripolymer of ethylene of propylene or silicone rubber, said material circumscribing said ribbons for making electrical connections between a plurality of contact pads.

FIG. 1

50 µm TYP.
SPACES

50 µm TYP.
FLAT WIRE
WIDTH

75 µm +/- 25 µm
Ⓐ TYP.

FIG. 5

5,6 mm

A            A

FIG. 3

SECTION A-A

5,6 mm

0,75 mm +/- 125 µm

FIG. 4

12,5 µm Au
0,5 µm Ni
12,5 µm Au

50 µm

FIG. 2